# EUROPEAN PATENT APPLICATION

(11) **EP 0 957 185 A2**
(43) Date of publication of application: **17.11.1999**
(21) Application number: 99104937.0
(22) Date of filing: 12.03.1999
(51) Int. Cl.: C30B 25/02, C30B 35/00, C23C 16/44

(54) **Apparatus for fabrication of thin film**

(30) Priority: 17.03.1998 JP 8805698
(71) Applicant: SHIN-ETSU HANDOTAI COMPANY LIMITED, Chiyoda-ku Tokyo (JP)
(72) Inventor: Habuka, Hitoshi, c/o Isobe R & D Center, 1-chome, Chiyoda-ku, Tokyo (JP)
(74) Representative: TER MEER STEINMEISTER & PARTNER GbR

(57) **Abstract**

The invention provides a thin film fabricating apparatus (10) capable of unloading the susceptor (12) from the process vessel (11) without exposing the interior of the process vessel (11) to outside air. In the apparatus (10) for fabricating a thin film by introducing raw material gas onto a surface of a substrate (1) placed on a susceptor (12) disposed in a process vessel (11), the susceptor (12) is transported from the process vessel (11) to a load lock chamber (19) adjacent to the process vessel (11) by a transportation unit (17). The substrate (1) and the susceptor (12) can be transported by the same transport unit (17).

## Description

### BACKGROUND OF THE INVENTION

This invention relates to a thin film fabricating apparatus for fabricating a thin film such as a silicon semiconductor single crystal thin film on the surface of a substrate such as a silicon semiconductor single crystal substrate.

Conventionally, it has been industrial practice to use a method that raw material gas is supplied onto a substrate, such as a silicon semiconductor single crystal substrate, placed and heated on a susceptor provided in a process vessel (reaction vessel), by which a thin film such as a semiconductor single crystal thin film is fabricated on the substrate.

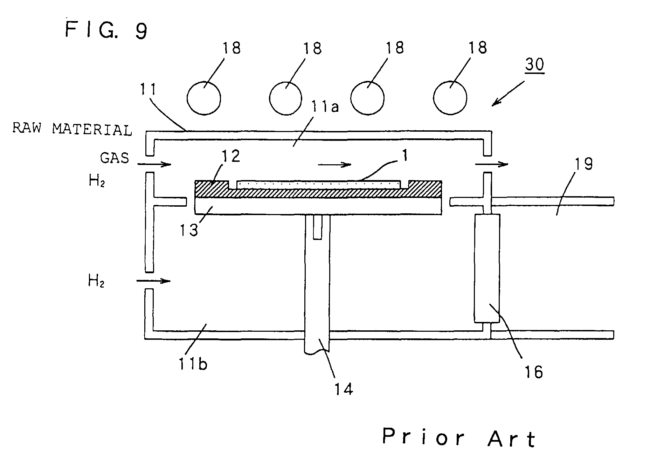

Fig. 9 shows an example of the thin film fabricating apparatus according to the prior art. This thin film fabricating apparatus 30 comprises, in a process vessel 11, a susceptor 12 for placing thereon a semiconductor single crystal substrate 1, a susceptor support 13 made of quartz glass or the like for supporting the susceptor 12, a shaft 14 for supporting and rotating the susceptor 12 and the susceptor support 13, and the like. Outside the process vessel 11 is provided an infrared lamp 18, which serves to increase the temperature of the semiconductor single crystal substrate 1 to a specified temperature via a transparent wall of the process vessel 11.

For forming a thin film on the surface of the semiconductor single crystal substrate 1 with the above apparatus, the semiconductor single crystal substrate 1 is increased in temperature to a specified temperature, and the raw material gas is supplied into a process chamber 11a together with hydrogen gas serving as a carrier gas, by which the raw material gas is put into reaction on the semiconductor single crystal substrate 1 so that a thin film is deposited. During the reaction, the process chamber 11a and a process vessel lower chamber 11b located below in the process vessel 11 are partitioned from each other by the susceptor 12. The process vessel lower chamber 11b is fed with hydrogen gas so that the pressure of the process vessel lower chamber 11b becomes slightly higher than that of the process chamber 11a. After the completion of the thin film formation process, the semiconductor single crystal substrate 1 with a thin film formed on the surface is lowered to the process vessel lower chamber 11b along with the susceptor 12 and the susceptor support 13, and then with a gate 16 opened, unloaded to a load lock chamber 19. The semiconductor single crystal substrate 1 unloaded to the load lock chamber 19 is either taken out as it is into a clean room, or as required, loaded to another processing equipment without being exposed to outside air. In addition, when a semiconductor single crystal substrate 1 to be newly processed is loaded into the process vessel 11, the above steps may be carried out in the reverse order.

The susceptor 12 in this case is a disc-shaped one whose base material is carbon and whose surface is coated with a silicon carbide or other film. This susceptor 12 is normally put into continuous use as it is installed within the process vessel 11, but needs to be replaced, in continuous use, once about one month or two months due to etching by hydrogen gas or deterioration by heat. Without this replacement, slip dislocation defects may generate due to variations in temperature distribution or nonuniform thickness distribution of the thin film may occur, during the thin film growth. In some cases, small voids may be formed in the coating film so as to penetrate to the carbon base material, allowing impurities such as carbon to ooze out into the reaction atmosphere through these holes. Accordingly, the replacement of the susceptor 12 is an essential process for the fabrication of thin films.

For the replacement of the susceptor 12 installed in the process vessel 11, conventionally, the procedure would be that a top face portion of the process chamber 11a is removed and then the susceptor 12 is taken out by inserting the hand through the removal portion. This would inevitably cause the interior of the process vessel 11 to be exposed to outside air.

In the case where the interior of the process vessel 11 is exposed to outside air in the replacement of the susceptor 12, as in the prior art, a great problem as shown below would occur. Exposing the interior of the process vessel 11 to outside air causes the air within the clean room, in which the thin film fabricating apparatus is installed, to invade the interior of the process vessel 11 so that moisture, organic contaminations and the like contained in the air within the clean room adhere to the inside wall of the process vessel 11 as well as to internal component parts. As a result, the moisture that has invaded reacts with the chlorine-base raw material gas and the like remaining in the process vessel 11 to generate hydrogen chloride, corroding SUS (stainless steel) or other metallic portions of the inside wall and the internal parts. Then, with the replacement process of the susceptor 12 completed, when the thin film fabrication is started, the moisture and organic contaminations that have been adhering to the inside wall of the process vessel 11 and the internal parts, as well as the corroded metals or the like gradually vaporize and mix into the thin film, causing the thin film to be degraded in characteristics and quality, as a problem. The moisture and organic contaminations that have been adhering to the inside wall of the process vessel 11 as well as the corroded metals decrease with increasing number of times of thin film growth, finally reaching a level of no problem. However, until such a level is reached, it is impossible to resume the manufacture of products, which has hitherto been a cause of considerable reduction in productivity.

The above problem can be solved by improving the material of the susceptor. One means therefor is, for example, to adopt a susceptor using a material having an extremely long life such as silicon carbide of simple substance. However, this susceptor is low in thermal conductivity and higher in price than susceptors using carbon as the base material, thus unsatisfactory in terms of feasibility. On the other hand, if the susceptor replacement work can be implemented without exposing the interior of the process vessel to outside air, a large effect can be expected.

### SUMMARY OF THE INVENTION

The invention having been accomplished in view of these and other issues, an object of the invention is to provide a thin film fabricating apparatus capable of loading/unloading the susceptor to/from the process vessel without exposing the interior of the process vessel to outside air.

In order to achieve the above object, the invention provides an apparatus for fabricating a thin film by introducing raw material gas onto a surface of a substrate placed on a susceptor disposed in a process vessel, characterized in that the susceptor is loaded from or loaded into the process vessel by a transport unit.

Preferably, the susceptor is unloaded by the transport unit after the susceptor has been moved vertically to a substrate unloading position at which the substrate is unloaded.

Preferably, the substrate unloading position is a position which is different, in the vertical direction, from a position at which the raw material gas is introduced into the process vessel.

Preferably, the substrate and the susceptor are unloaded from or loaded into the process vessel by using the same transport unit.

Preferably, the susceptor is loaded or unloaded while the substrate keeps placed on the susceptor.

Preferably, the substrate and the susceptor are unloaded from or loaded into the process vessel by using different units, respectively.

The invention also provides an apparatus for fabricating a thin film by introducing raw material gas onto a surface of a substrate placed on a susceptor disposed in a process vessel, characterized in that interior of the process vessel is maintained in a hydrogen gas or inactive gas atmosphere while the susceptor is unloaded from the process vessel.

According to the present invention, by eliminating the process in which the interior of the process vessel is exposed to the air during the replacement of the susceptor, moisture and organic contaminations and the like within the air can be prevented from invading the interior of the process vessel, so that the interior of the process vessel can be maintained in an extremely clean state. Accordingly, immediately after the completion of the susceptor replacement process, fabrication of an extremely clean semiconductor single crystal thin film or the like can be started.

In other words, according to the present invention, since the susceptor can be transported to the load lock chamber without causing the interior of the process vessel to be exposed to outside air, moisture and organic contaminations and the like contained in the air within the clean room can be prevented from invading the interior of the process vessel during the transportation of the susceptor. Thus, the interior of the process vessel can be maintained in an extremely clean state and therefore an extremely clean semiconductor single crystal thin film can be obtained.

### BRIEF DESCRIPTION OF THE DRAWINGS

Fig. 1 is a schematic arrangement view showing an example of the thin film fabricating apparatus of the invention;
Figs. 2A and 2B are plan views showing an example of the susceptor and the susceptor support in the thin film fabricating apparatus of the invention;
Figs. 3A - 3C are process explanatory views showing the process of taking out the semiconductor single crystal substrate in the thin film fabricating apparatus of the invention;
Figs. 4D - 4F are process explanatory views showing the process of taking out the semiconductor single crystal substrate in the thin film fabricating apparatus of the invention;
Figs. 5A to 5C are process explanatory views showing the process of taking out the susceptor in the thin film fabricating apparatus of the invention;
Figs. 6D - 6F are process explanatory views showing the process of taking out the susceptor in the thin film fabricating apparatus of the invention;
Fig. 7 is a schematic arrangement view showing another example of the thin film fabricating apparatus of the invention;
Figs. 8A - 8B are process explanatory views showing the process of taking out the semiconductor single crystal substrate or the susceptor in the thin film fabricating apparatus of the invention; and
Fig. 9 is a schematic arrangement view showing an example of the thin film fabricating apparatus of the prior art.

### DESCRIPTION OF THE INVENTION AND PREFERRED EMBODIMENT THEREOF

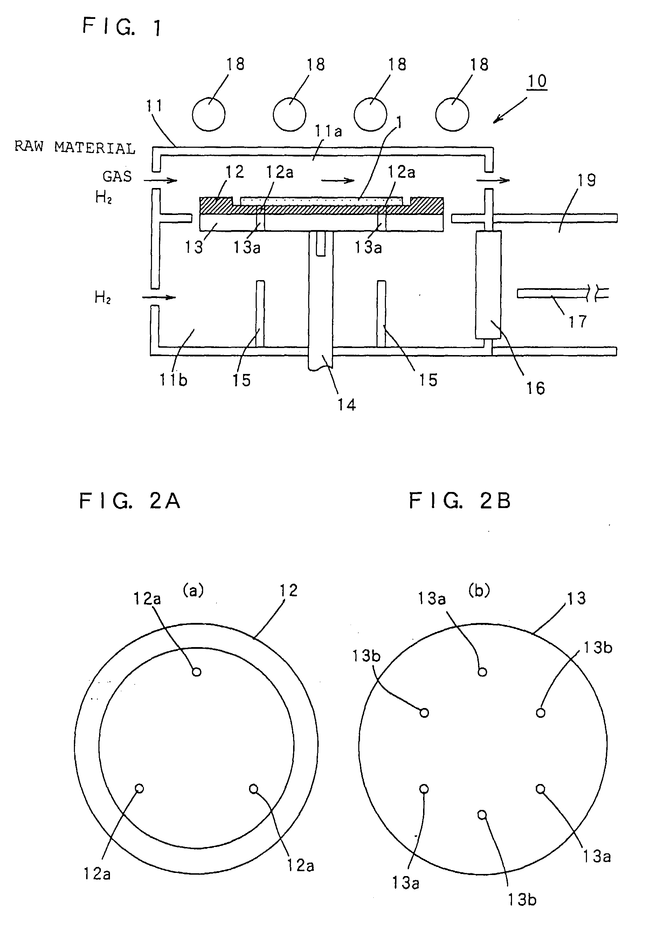

The thin film fabricating apparatus of the invention will now be described with reference to the accompanying drawings. Fig. 1 shows an example of the embodiment of the thin film fabricating apparatus of the invention. This thin film fabricating apparatus 10, like the prior art apparatus shown in Fig. 9, comprises in a process vessel 11 a susceptor 12 for placing thereon a semiconductor single crystal substrate 1, a susceptor support 13 for supporting the susceptor 12, and a shaft 14 for supporting and rotating the susceptor 12 and the susceptor support 13. Outside the process vessel 11 is provided an infrared lamp 18, which serves to increase the temperature of the semiconductor single crystal substrate 1 to a specified temperature via a transparent wall of the process vessel 11. It is noted that component members designated by the same reference numerals as in Fig. 9 are the same or equivalent component members.

In this thin film fabricating apparatus 10, three pins 15 made of quartz glass or the like that are standing vertically below the susceptor support 13 are so arranged as to be positioned at vertices of a triangle, respectively. Also, as shown in Fig. 2A, the susceptor 12 has three through holes 12a formed at positions for the three pins 15 to be inserted through. Further, as shown in Fig. 2B, the susceptor support 13 also has three through holes 13a formed at positions for the three pins 15 to be inserted through, and besides three through holes 13b formed at positions corresponding to the three through holes 13a that have been rotated a specified angle.

Also, the process vessel 11 is equipped with a load lock chamber 19 in adjacency via a gate 16, and a transport unit 17 for transporting the semiconductor single crystal substrate 1 and the susceptor 12 from the process vessel 11 to the load lock chamber 19 is provided in the load lock chanter 19. The load lock chamber 19 is provided in order to load and unload the semiconductor single crystal substrate 1 into and out of the process vessel without exposing the interior of the process vessel 11 to outside air. The interior of the load lock chamber 19 is maintained to a hydrogen gas atmosphere or an inactive gas atmosphere such as nitrogen.

Next, the process for unloading the susceptor 12 from the process vessel 11 to the load lock chamber 19 in the apparatus is explained. In addition, for this apparatus, it is possible to unload the semiconductor single crystal substrate 1 from the process vessel 11 either along with the susceptor 12 or singly by using the transport unit 17. Therefore, the process for taking out the semiconductor single crystal substrate 1 is first described and then the process for unloading the susceptor 12 with the semiconductor single crystal substrate 1 placed thereon is described. In the figures showing these unloading processes, the infrared lamp 18 is omitted in illustration.

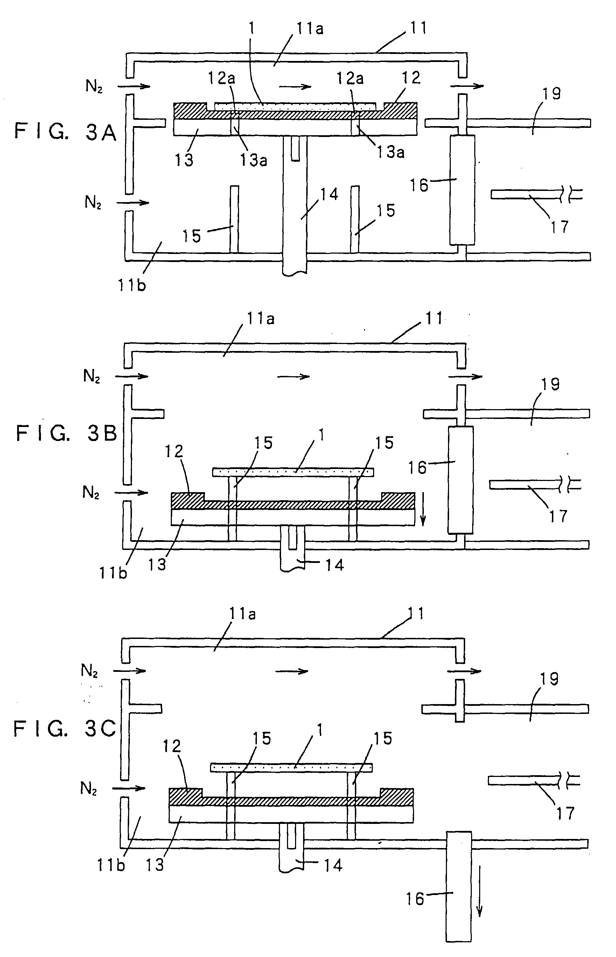

Figs. 3A - 3C and Figs. 4D - 4E show the process for unloading the semiconductor single crystal substrate 1 alone. First, after the completion of the thin film formation process, interior of the process vessel 11 of hydrogen atmosphere is purged with nitrogen gas (Fig. 3A). Then, the shaft 14 is rotated a specified angle so that the three through holes 12a of the susceptor 12 and the three through holes 13a of the susceptor support 13 are positioned coaxial with the three pins 15, respectively. In this state, the shaft 14 is moved downward so that the pins 15 are inserted through the through holes of the susceptor 12 and the susceptor support 13, respectively. Then, only the semiconductor single crystal substrate 1 is rested on the three pins 15, while the susceptor 12 and the susceptor support 13 are further lowered (Fig. 3B).

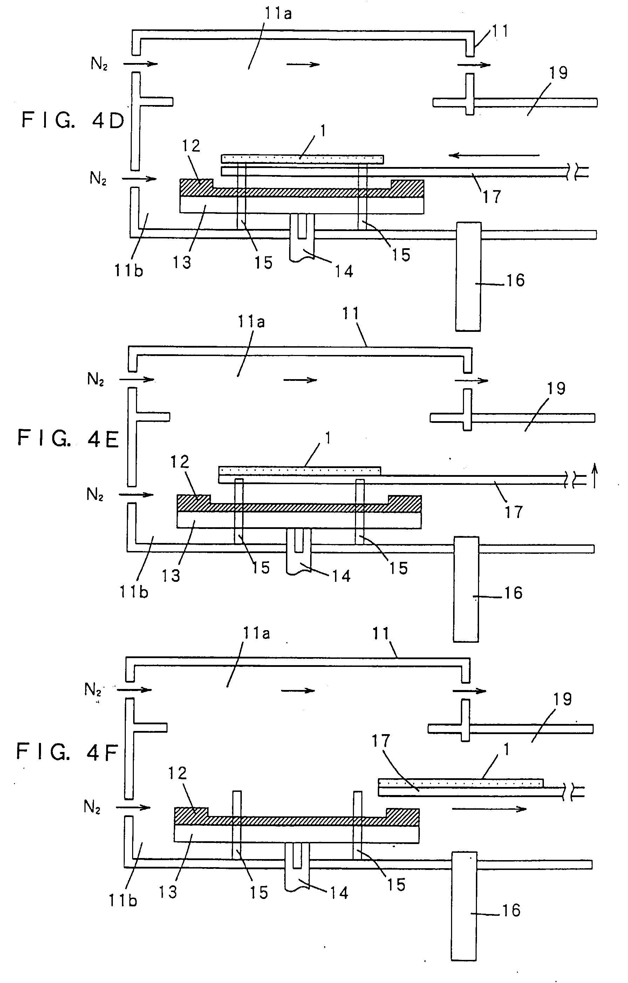

Next, with the gate 16 opened (Fig. 3C), the transport unit 17 is inserted into the process vessel lower chamber 11b so as to be positioned between the semiconductor single crystal substrate 1 supported on the three pins 15 and the susceptor 12 (Fig. 4D). Then, the transport unit 17 is moved slightly upward, by which the semiconductor single crystal substrate 1 is rested on the transport unit 17 and lifted from the pins 15 (Fig. 4E). In this state, the transport unit 17 is pulled back to the load lock chamber 19, by which the semiconductor single crystal substrate 1 is unloaded from the process vessel 11 to the load lock chamber 19 (Fig. 4F).

The semiconductor single crystal substrate 1 taken out to the load lock chamber 19 is either stored in a cassette so as to be taken out of the thin film fabricating apparatus 10, or as required, loaded to another processing equipment. In addition, when a semiconductor single crystal substrate 1 to be newly processed is loaded into the process vessel 11, steps in the order reverse to the above, i.e., an order of Fig. 4F → 4E → 4D → Fig. 3C → 3B → 3A may appropriately be taken.

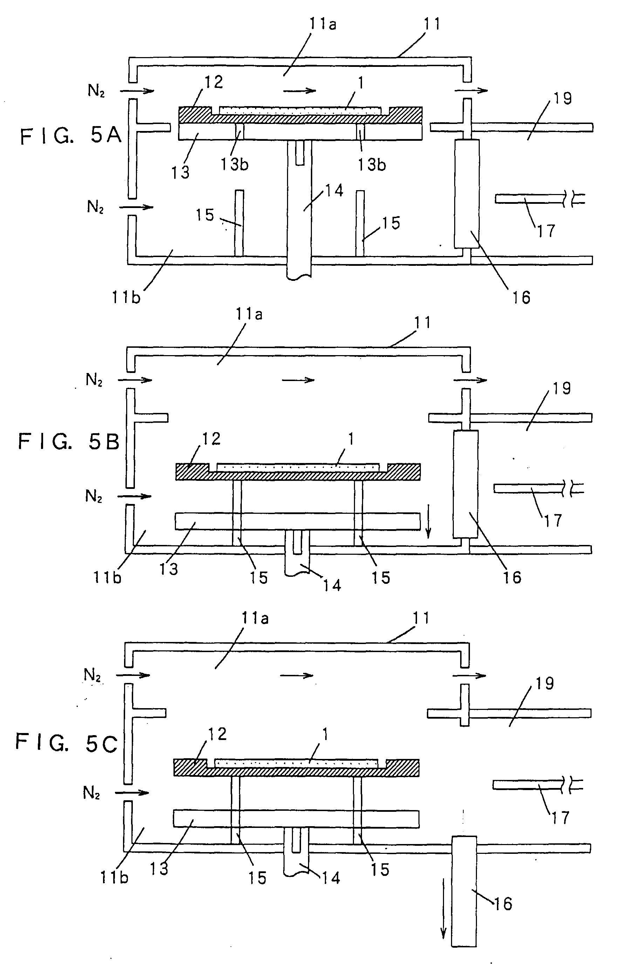

Figs. 5A - 5C and Figs. 6D - 6E show the process for taking out the susceptor 12 with the semiconductor single crystal substrate 1 placed thereon. It is noted that the process for taking out only the susceptor 12 with no semiconductor single crystal substrate 1 placed thereon is also carried out in absolutely the same way. First, after the completion of the thin film formation process, the interior of the process vessel 11 is purged with nitrogen gas (Fig. 5A). Then, the shaft 14 is rotated a specified angle so that the three through holes 13b of the susceptor support 13 are positioned coaxial with the three pins 15, respectively. In this state, the shaft 14 is moved downward, by which the pins 15 are inserted through the through holes 13b of the susceptor support 13, respectively, while the susceptor 12 with the semiconductor single crystal substrate 1 placed thereon is supported on the three pins 15 because the through holes 12a of the susceptor 12 are located at shifted positions. Thus, only the susceptor support 13 are further lowered (Fig. 5B).

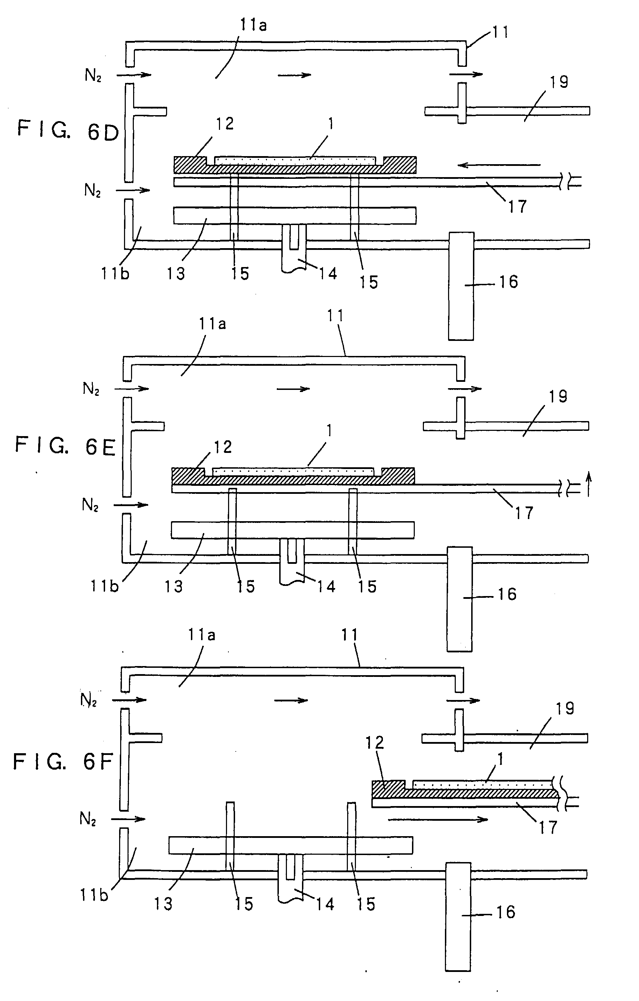

Next, with the gate 16 opened (Fig. 5C), the transport unit 17 is inserted into the process vessel lower chamber 11b so as to be positioned between the susceptor 12 supported on the three pins 15 and the susceptor support 13 (Fig. 6D). Then, the transport unit 17 is moved slightly upward, by which the susceptor 12 is rested on the transport unit 17 and lifted from the pins 15 (Fig. 6E). In this state, the transport unit 17 is pulled back to the load lock chamber 19, by which the susceptor 12 with the semiconductor single crystal substrate 1 placed thereon is unloaded from the process vessel 11 to the load lock chamber 19 (Fig. 6F).

When the same susceptor 12 with a new semiconductor single crystal substrate 1 placed thereon is loaded into the process vessel 11 once again or when a new susceptor 12 is loaded, steps in the order reverse to the above, i.e., an order of Fig. 6F → 6E → 6D → Fig. 5C → 5B → 5A may appropriately be taken.

In addition, by rotating and lowering the shaft 14 so that the pins 15 are located at positions where the through holes 13b of the susceptor support 13 are absent, the susceptor support 13 also can be rested on the pins 15, so that the susceptor support 13 can also be unloaded.

The transport unit 17 may be a transport unit used for the transportation of wafers in ordinary thin film fabricating apparatuses, the transport unit being so designed that an arm having a wafer holding portion at its tip end is expanded and contracted, moved back and forth and rotated by a motor or a driver using hydraulic or gaseous pressure. The wafer holding portion at the tip end of the arm is formed into a rod- or plate-shaped fork, doughnut type ring, or a grid-like meshed square frame. A vacuum suction or electrostatic suction head is also usable. The transport unit 17 is, preferably, provided for heavy weight measures with a view to transporting susceptors, which are heavyweight as compared with wafers.

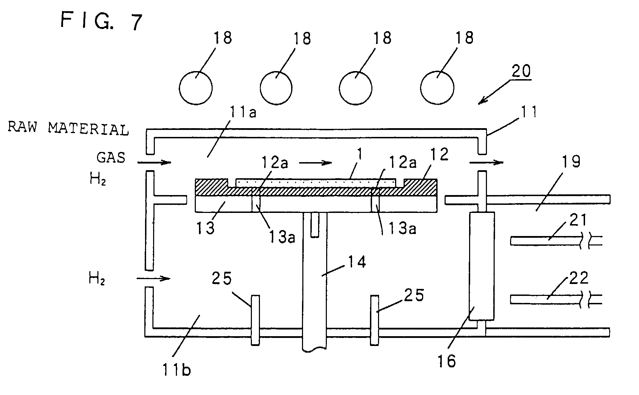

Fig. 7 shows another example of the embodiment of the thin film fabricating apparatus according to the invention. This thin film fabricating apparatus 25, which is similar in basic construction to the apparatus shown in Fig. 1, further comprises a transport unit 21 for transporting the semiconductor single crystal substrate 1 alone, and another transport unit 22, separate from the transport unit 21, for transporting the susceptor 12. Three pins 25 provided at the same positions as in Fig. 1 and standing vertically are extendable and contractible up to an arbitrary height in the vertical direction.

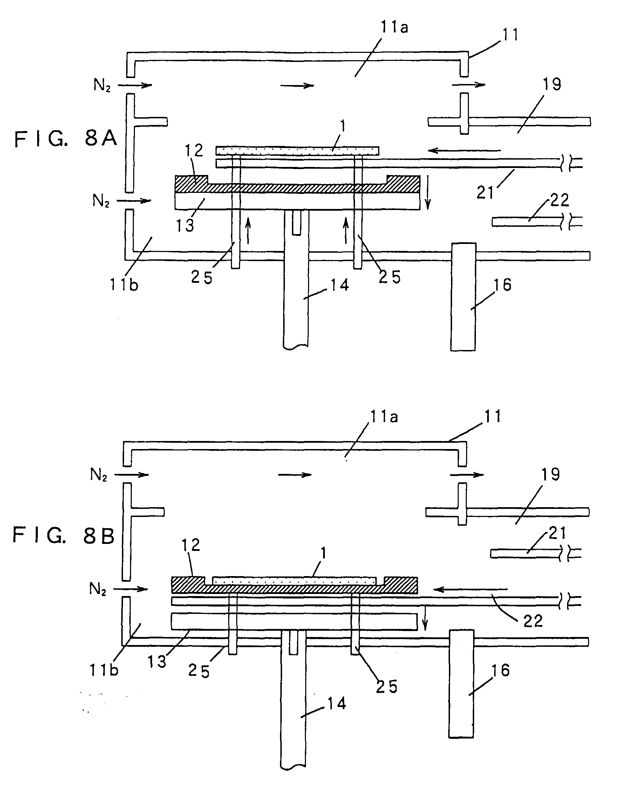

In this apparatus, when only the semiconductor single crystal substrate 1 is unloaded, the pins 25 are extended to a unloading height of the semiconductor single crystal substrate 1 as shown in Fig. 8A, and the pins 25 are inserted through the through holes 12a and 13a of the susceptor 12 and the susceptor support 13, respectively, thus allowing the semiconductor single crystal substrate 1 to be rested on the pins 25. Then, the transport unit 21 for substrate transport use is inserted between the semiconductor single crystal substrate 1 and the susceptor 12, and moved slightly upward, by which the semiconductor single crystal substrate 1 is lifted from the pins 25, and then unloaded. In this way, the semiconductor single crystal substrate 1 alone can be unloaded.

Also, when the susceptor 12 is unloaded with the semiconductor single crystal substrate 1 keeping placed thereon, the pins 25 are extended to the unloading height of the susceptor 12 as shown in Fig. 8B, and the pins 25 are inserted through the through holes 13b of the susceptor support 13, respectively, allowing the susceptor 12 to be rested on the pins 25. Then, the transport unit 22 for susceptor transport use is inserted between the susceptor 12 and the susceptor support 13, and moved slightly upward, by which the susceptor 12 is lifted from the pins 25, and then unloaded. In this way, the susceptor 12 with the semiconductor single crystal substrate 1 placed thereon can be unloaded.

As described above, when transport units are provided separately and individually for transport of the semiconductor single crystal substrate and for transport of the susceptor, the semiconductor single crystal substrate 1, which is relatively lightweight, and the susceptor 12, which is relatively heavyweight, can be transported by their respectively matching transport units, thus ensuring more reliable transport work. It becomes also possible to implement the transport of the semiconductor single crystal substrate 1 on the process chamber 11a side.

The transport unit 21 may be a transport unit used for the transportation of wafers in ordinary thin film fabricating apparatuses. The transport unit 22 may be a transport unit similar in basic construction to the transport unit 17, but preferably one provided for heavy weight measures with a view to transporting susceptors, which are heavyweight as compared with wafers.

The above description has been made on a case in which interior of the process vessel 11 of hydrogen atmosphere is purged with nitrogen gas before the susceptor 12 is unloaded from the process vessel 11 to the load lock chamber 19. Otherwise, the susceptor 12 may be unloaded to the load lock chamber 19 while the interior of the process vessel 11 is maintained in the hydrogen atmosphere. However, because hydrogen flows into the load lock chamber 19, it is preferable that the load lock chamber 19 is purged sufficiently with nitrogen or other inactive gas after the gate 16 is closed. Also, although three pins are arranged so as to be positioned at vertices of a triangle in the above-described examples, the arrangement of the pins is not limited to this, nor is the number of pins limited. Also as to the process for separating the semiconductor single crystal substrate and the susceptor from each other in the vertical direction, the above case in which pins are provided is by way of example only, and other constitutions are also possible. Further, it is needless to say that various modifications and changes may be made for the configuration of the susceptor and the susceptor support, the configuration of the transport units and the like.

## Claims

1. An apparatus (10) for fabricating a thin film by introducing raw material gas onto a surface of a substrate (1) placed on a susceptor (12) disposed in a process vessel (11), characterized in that the susceptor (12) is unloaded from or loaded into the process vessel (11) by a transport unit (17).

2. An apparatus for fabricating a thin film according to Claim 1, wherein said susceptor (12) is unloaded by said transport unit (17) after said susceptor (12) has been moved vertically to a substrate unloading position at which said substrate (1) is unloaded.

3. An apparatus for fabricating a thin film according to Claim 2, wherein the substrate unloading position is a position which is different, in the vertical direction, from a position at which said raw material gas is introduced into said process vessel (11).

4. An apparatus for fabricating a thin film according to any one of Claims 1 to 3, wherein said substrate (1) and said susceptor (12) are unloaded from or loaded into said process vessel (11) by using the same transport unit (17).

5. An apparatus for fabricating a thin film according to any one of Claims 1 to 4, wherein said susceptor (12) is loaded or unloaded while said substrate (1) keeps placed on said susceptor (12).

6. An apparatus for fabricating a thin film according to any one of Claims 1 to 3, wherein said substrate (1) and said susceptor (12) are unloaded from or loaded into said process vessel (11) by using different units, respectively.

7. An apparatus (10) for fabricating a thin film by introducing raw material gas onto a surface of a substrate (1) placed on a susceptor (12) disposed in a process vessel (11), characterized in that interior of the process vessel (11) is maintained in a hydrogen gas or inactive gas atmosphere while the susceptor (12) is unloaded from the process vessel (11).
